# EUROPEAN PATENT APPLICATION

(11) **EP 3 461 042 A1**
(43) Date of publication of application: **27.03.2019**
(21) Application number: 16911083.0
(22) Date of filing: 03.08.2016
(51) Int. Cl.: H04L 1/00

(54) **DATA TRANSMISSION METHOD AND DEVICE**

(71) Applicant: Guangdong OPPO Mobile Telecommunications Corp., Ltd., Guangdong 523860 (CN)
(72) Inventor: TANG, Hai, Dongguan Guangdong 523860 (CN)
(74) Representative: Manitz Finsterwald Patent- und Rechtsanwaltspartnerschaft mbB
(86) International application number: PCT/CN2016/093045
(87) International publication number: WO 2018/023485

(57) **Abstract**

Embodiments of the present invention provide a data transmission method and device. The method includes: determining, by a transmitting end, a channel coding scheme for to-be-transmitted data according to at least one of a size of a transport block of the to-be-transmitted data, a numerology used for the to-be-transmitted data and a service type of the to-be-transmitted data; performing, by the transmitting end, channel coding for the to-be-transmitted data by using the channel coding scheme for the to-be-transmitted data; and transmitting, by the transmitting end, the to-be-transmitted data that is performed with the channel coding to a receiving end. The embodiments of the present invention can select an appropriate channel coding scheme for the to-be-transmitted data.

## Description

### TECHNICAL FIELD

The present invention relates to the field of wireless communication technologies and, more particularly, to a data transmission method and a device.

### BACKGROUND

In a long term evolution (LTE) system, Turbo coding is generally used for channel coding to meet requirements of data transmission in LTE.

However, in the fifth generation mobile communication technology (5G), different data transmissions may vary in terms of service types, sizes of transport blocks, or numerologies used. Therefore, it is difficult to meet requirements of different data transmissions by using a single coding scheme.

### SUMMARY

The present invention provides a data transmission method and device to select an appropriate channel coding scheme for to-be-transmitted data.

In a first aspect, a data transmission method is provided, including: determining, by a transmitting end, a channel coding scheme for to-be-transmitted data according to at least one of a size of a transport block of the to-be-transmitted data, a numerology used for the to-be-transmitted data and a service type of the to-be-transmitted data; performing, by the transmitting end, channel coding for the to-be-transmitted data by using the channel coding scheme for the to-be-transmitted data; and transmitting, by the transmitting end, the to-be-transmitted data that is performed with the channel coding to a receiving end.

Compared with a single channel coding scheme used in an LTE system, in an embodiment of the present invention, an appropriate channel coding scheme can be selected for to-be-transmitted data according to feature information of the to-be-transmitted data by determining a channel coding scheme for the to-be-transmitted data according to at least one of a size of a transport block of the to-be-transmitted data, a numerology used for the to-be-transmitted data and a service type of the to-be-transmitted data.

In conjunction with the first aspect, in some implementations of the first aspect, determining, by the transmitting end, the channel coding scheme for the to-be-transmitted data according to the size of the transport block of the to-be-transmitted data includes: determining, by the transmitting end, the channel coding scheme for the to-be-transmitted data according to the size of the transport block of the to-be-transmitted data and a correspondence relationship between the size of the transport block and the channel coding scheme.

In conjunction with the first aspect, in some implementations of the first aspect, the determining, by the transmitting end, the channel coding scheme for the to-be-transmitted data according to the size of the transport block of the to-be-transmitted data and the correspondence relationship between the size of the transport block and the channel coding scheme includes: determining, by the transmitting end, a channel coding scheme for a first transport block according to a size of the first transport block of the to-be-transmitted data and the correspondence relationship between the size of the transport block and the channel coding scheme.

In an embodiment of the present invention, an appropriate channel coding scheme can be determined for each transport block carrying to-be-transmitted data.

In conjunction with the first aspect, in some implementations of the first aspect, the determining, by the transmitting end, the channel coding scheme for the to-be-transmitted data according to the size of the transport block of the to-be-transmitted data and the correspondence relationship between the size of the transport block and the channel coding scheme includes: determining, by the transmitting end, channel coding schemes for all transport blocks of the to-be-transmitted data according to a size of a second transport block of the to-be-transmitted data and the correspondence relationship between the size of the transport block and the channel coding scheme.

In conjunction with the first aspect, in some implementations of the first aspect, the second transport block is the largest transport block or the smallest transport block among all transport blocks of the to-be-transmitted data.

In an embodiment of the present invention, channel coding schemes for all transport blocks carrying to-be-transmitted data are determined through the largest transport block or the smallest transport block and all transport blocks use the same channel coding scheme, which simplifies a process and a step of determining the channel coding scheme.

In conjunction with the first aspect, in some implementations of the first aspect, determining, by the transmitting end, the channel coding scheme for the to-be-transmitted data according to the numerology used for the to-be-transmitted data includes: determining, by the transmitting end, the channel coding scheme for the to-be-transmitted data according to the numerology used for the to-be-transmitted data and a correspondence relationship between information in the numerology and the channel coding scheme.

In conjunction with the first aspect, in some implementations of the first aspect, the numerology includes at least one of: a subcarrier spacing; the number of subcarriers in a preset bandwidth; the number of subcarriers included in a physical resource block (PRB); a length of an orthogonal frequency division multiplexing (OFDM) symbol; the number of points used by Fourier transform or inverse Fourier transform to generate an OFDM signal; the number of OFDM symbols included in each transmission time interval (TTI); the number of TTIs included in a preset time unit; and signal prefix information.

In conjunction with the first aspect, in some implementations of the first aspect, determining, by the transmitting end, the channel coding scheme for the to-be-transmitted data according to the service type of the to-be-transmitted data includes: determining, by the transmitting end, the channel coding scheme for the to-be-transmitted data according to the service type of the to-be-transmitted data and a correspondence relationship between the service type and the channel coding scheme.

In conjunction with the first aspect, in some implementations of the first aspect, the service type of the to-be-transmitted data is any one of long term evolution system (LTE) data, an enhanced mobile broadband (eMBB), ultra-reliable and low latency communications (URLLC), and massive machine type communications (mMTC).

In conjunction with the first aspect, in some implementations of the first aspect, the channel coding scheme is any one of: low-density parity check (LDPC) coding; Turbo coding; Polar coding; Tail-Biting Convolutional Coding (TBCC); and Reed-Muller (RM) coding.

In a second aspect, a data transmission method is provided, including: receiving, by a receiving end, first data transmitted by a transmitting end; determining, by the receiving end, a channel coding scheme for first data according to at least one of a size of a transport block of the first data, a numerology used for the first data and a service type of the first data; and performing, by the receiving end, channel decoding for the first data based on a channel decoding scheme corresponding to the channel coding scheme for the first data.

Compared with a single channel coding scheme used in an LTE system, in an embodiment of the present invention, an appropriate channel coding scheme can be selected for to-be-transmitted data according to feature information of the to-be-transmitted data by determining a channel coding scheme for to-be-transmitted data according to at least one of a size of a transport block of the to-be-transmitted data, a numerology used for the to-be-transmitted data and a service type of the to-be-transmitted data.

In conjunction with the second aspect, in some implementations of the second aspect, determining, by the receiving end, the channel coding scheme for the first data according to the size of the transport block of the first data includes: determining, by the receiving end, the channel coding scheme for the first data according to the size of the transport block of the first data and a correspondence relationship between the size of the transport block and the channel coding scheme.

In conjunction with the second aspect, in some implementations of the second aspect, the determining, by the receiving end, the channel coding scheme for the first data according to the size of the transport block of the first data and the correspondence relationship between the size of the transport block and the channel coding scheme includes: determining, by the receiving end, a channel coding scheme for a first transport block according to a size of the first transport block of the first data and the correspondence relationship between the size of the transport block and the channel coding scheme.

In conjunction with the second aspect, in some implementations of the second aspect, the determining, by the receiving end, the channel coding scheme for the first data according to the size of the transport block of the first data and the correspondence relationship between the size of the transport block and the channel coding scheme includes: determining, by the receiving end, channel coding schemes for all transport blocks of the first data according to a size of a second transport block of the first data and the correspondence relationship between the size of the transport block and the channel coding scheme.

In conjunction with the second aspect, in some implementations of the second aspect, the second transport block is the largest transport block or the smallest transport block among all transport blocks of the to-be-transmitted data.

In conjunction with the second aspect, in some implementations of the second aspect, determining, by the receiving end, the channel coding scheme for the first data according to the numerology used for the first data includes: determining, by the receiving end, the channel coding scheme for the first data according to the numerology used for the first data and a correspondence relationship between information in the numerology and the channel coding scheme.

In conjunction with the second aspect, in some implementations of the second aspect, the numerology includes at least one of: a subcarrier spacing; the number of subcarriers in a preset bandwidth; the number of subcarriers included in a physical resource block (PRB); a length of an orthogonal frequency division multiplexing (OFDM) symbol; the number of points used by Fourier transform or inverse Fourier transform to generate an OFDM signal; the number of OFDM symbols included in each transmission time interval (TTI); the number of TTIs included in a preset time unit; and signal prefix information.

In conjunction with the second aspect, in some implementations of the second aspect, determining, by the receiving end, the channel coding scheme for the first data according to the service type of the first data includes: determining, by the receiving end, the channel coding scheme for the first data according to the service type of the first data and a correspondence relationship between the service type and the channel coding scheme.

In conjunction with the second aspect, in some implementations of the second aspect, the service type of the first data is any one of long term evolution system (LTE) data, an enhanced mobile broadband (eMBB), ultra-reliable and low latency communications (URLLC), and massive machine type communications (mMTC).

In conjunction with the second aspect, in some implementations of the second aspect, the channel coding scheme is any one of: low-density parity check (LDPC) coding; Turbo coding; Polar coding; Tail-Biting Convolutional Coding (TBCC); and Reed-Muller (RM) coding.

In a third aspect, a data transmission device is provided, where the device includes a module for performing the method of the first aspect.

In a fourth aspect, a data transmission device is provided, where the device includes a module for performing the method of the second aspect.

In a fifth aspect, a data transmission device is provided, including a memory, a transceiver, and a processor, where the memory is configured to store a program, the processor is configured to execute the program, and when the program is executed, the processor is configured to perform the method of the first aspect based on the transceiver.

In a sixth aspect, a data transmission device is provided, including a memory, a transceiver, and a processor, where the memory is configured to store a program, the processor is configured to execute the program, and when the program is executed, the processor is configured to perform the method of the first aspect based on the transceiver.

In a seventh aspect, a computer readable medium is provided, where the computer readable medium is configured to store a device executable program code including an instruction for performing the method of the first aspect.

In an eighth aspect, a computer readable medium is provided, where the computer readable medium is configured to store a device executable program code including an instruction for performing the method of the second aspect.

### BRIEF DESCRIPTION OF DRAWINGS

FIG. 1 is a schematic flow chart of a data transmission method according to an embodiment of the present invention;
FIG. 2 is a schematic flow chart of a data transmission method according to an embodiment of the present invention;
FIG. 3 is a schematic block diagram of a data transmission device according to an embodiment of the present invention;
FIG. 4 is a schematic block diagram of a data transmission device according to an embodiment of the present invention;
FIG. 5 is a schematic block diagram of a data transmission device according to an embodiment of the present invention; and
FIG. 6 is a schematic block diagram of a data transmission device according to an embodiment of the present invention.

### DESCRIPTION OF EMBODIMENTS

It should be understood that technical solutions of embodiments of the present invention are applicable to various communication systems, e.g., current communication systems such as a global system of mobile communication (GSM), a code division multiple access (CDMA) system, a wideband code division multiple access (WCDMA) system, a general packet radio service (GPRS), a long term evolution (LTE) system, a universal mobile telecommunication system (UMTS) and the like, especially applicable to future fifth generation mobile communication technology (5G) systems.

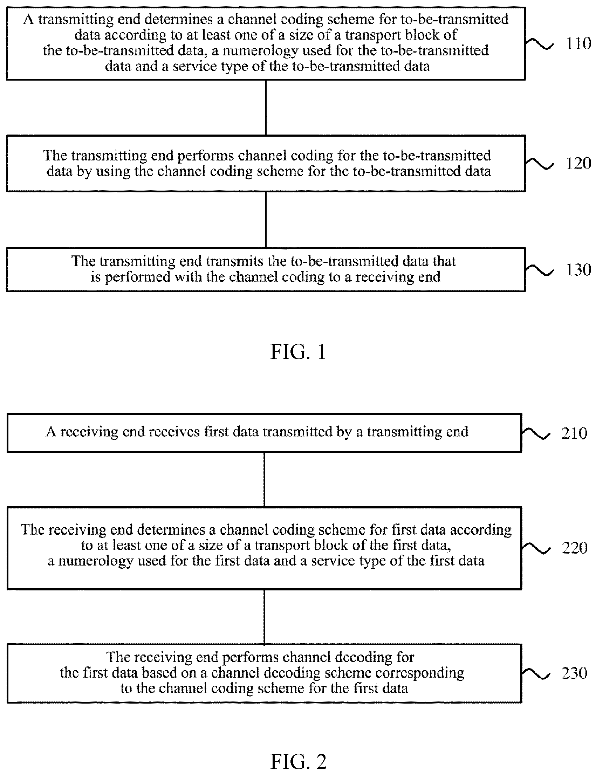

FIG. 1 is a schematic flow chart of a data transmission method according to an embodiment of the present invention. The method as shown in FIG. 1 includes:

110: a transmitting end determines a channel coding scheme for to-be-transmitted data according to at least one of a size of a transport block of the to-be-transmitted data, a numerology used for the to-be-transmitted data and a service type of the to-be-transmitted data.

It should be understood that the above transport block is a transport block carrying the above to-be-transmitted data, and the size of the transport block is a transport block size (TBSize). There may be one or more transport blocks carrying the to-be-transmitted data. In addition, the size of the transport block of the to-be-transmitted data, the numerology used for the to-be-transmitted data, and the service type of the to-be-transmitted data may be considered as feature information of the to-be-transmitted data. An appropriate channel modulation scheme may be selected for the to-be-transmitted data by using the feature information of the to-be-transmitted data.

120: the transmitting end performs channel coding for the to-be-transmitted data by using the channel coding scheme for the to-be-transmitted data.

For example, in Step 110, the transmitting end determines that the channel coding scheme for the to-be-transmitted data is Polar coding, and then in Step 120, the transmitting end performs channel coding for the to-be-transmitted data by using the Polar coding.

130: the transmitting end transmits the to-be-transmitted data that is performed with the channel coding to a receiving end.

It should be understood that both the transmitting end and the receiving end in embodiments of the present invention may be a network side device or a terminal device. The common situation is that the transmitting end is a network side device and the receiving end is a terminal device, or both the transmitting end and the receiving end are terminal devices.

The network side device in the embodiments of the present invention may be a device for communicating with the terminal device, where the network side device may be a base station (Base Transceiver Station, BTS) in the GSM or the CDMA, or may be a base station (NodeB, NB) in the WCDMA system, or may be an evolved base station (Evolutional NodeB, eNB or eNodeB) in the LTE system, or may be a wireless controller in a cloud radio access network (CRAN) scenario. Alternatively, the network device may be a relay station, an access point, an in-vehicle device, a wearable device, and a network side device in a future 5G network or a network side device in a future evolved PLMN network, etc., which is not limited in the embodiments of the present invention.

The terminal device in the embodiments of the present invention may refer to user equipment (UE), an access terminal, a subscriber unit, a subscriber station, a mobile station, a mobile station, a remote station, a remote terminal, a mobile device, a user terminal, a terminal, a wireless communication device, a user agent or a user device. The access terminal may be a cellular phone, a cordless phone, a session initiation protocol (SIP) phone, a wireless local loop (WLL) station, a personal digital assistant (PDA), a handheld device with wireless communication capabilities, a computing device or other processing devices connected to a wireless modem, an in-vehicle device, a wearable device, a terminal device in a future 5G network, a terminal device in a future evolved public land mobile network (PLMN) or the like, which is not limited in the embodiments of the present invention.

Compared with a single channel coding scheme used in an LTE system, in an embodiment of the present invention, an appropriate channel coding scheme can be selected for to-be-transmitted data according to feature information of the to-be-transmitted data by determining a channel coding scheme for the to-be-transmitted data according to at least one of a size of a transport block of the to-be-transmitted data, a numerology used for the to-be-transmitted data and a service type of the to-be-transmitted data.

Optionally, as an embodiment, the transmitting end determines the channel coding scheme for the to-be-transmitted data according to the size of the transport block of the to-be-transmitted data and a correspondence relationship between the size of the transport block and the channel coding scheme. The correspondence relationship between the size of the transport block and the channel coding scheme may be preset.

It should be understood that the size of the transport block of the to-be-transmitted data may be determined according to modulation and coding scheme (MCS) indication information included in a control signaling for scheduling the to-be-transmitted data. Specifically, a data block size of the to-be-transmitted data may be determined according to an MCS indicated in the MCS indication information and a frequency domain resource size of the to-be-transmitted data (the frequency domain resource size may be determined by frequency domain resource configuration information scheduling the to-be-transmitted data). A correspondence relationship between the MCS/the frequency domain resource size and the transport block size may be predetermined by the transmitting end and the receiving end, so that the transmitting end and the receiving end may directly determine the transport block size of the to-be-transmitted data according to the MCS and the frequency domain resource size of the to-be-transmitted data. In addition, the transport block size of the to-be-transmitted data also may be directly determined according to the MCS and the transport block size.

When the transmitting end determines the channel coding scheme for the to-be-transmitted data according to the transport block size of the to-be-transmitted data and the correspondence relationship between the transport block size and the channel coding scheme, the following two manners may be used:

### Manner 1:

The transmitting end determines a channel coding scheme for a first transport block according to a size of the first transport block of the to-be-transmitted data and the correspondence relationship between the size of the transport block and the channel coding scheme. It should be understood that the determining of the channel coding scheme for the first transport block refers to determining a coding scheme for data carried in the first transport block, and then the transmitting end will perform channel coding for the data carried in the first transport block according to the coding scheme for the data carried in the first transport block. The first transport block described above may be any transport block of the to-be-transmitted data, or may be a specific transport block of the to-be-transmitted data.

When the first transport block described above is any transport block of the to-be-transmitted data, for example, the to-be-transmitted data includes two transport blocks, channel coding schemes corresponding to the two respective transport blocks may be then determined according to Manner 1, respectively. That is to say, in Manner 1, the channel coding scheme of each transport block may be determined, and then the respective transport blocks are performed with channel coding according to the determined channel coding scheme.

Specifically, it is assumed that the to-be-transmitted data includes two transport blocks, a transport block 1 and a transport block 2 respectively. When the size of the transport block 1 is less than or equal to a preset first threshold, it is determined that the channel coding scheme for the transport block 1 is Polar coding; when the size of the transport block 1 is greater than the preset first threshold, it is determined that the channel coding scheme for the transport block 1 is Turbo coding. Likewise, for the transport block 2, when the size of the transport block 2 is less than or equal to a preset first threshold, it is determined that the channel coding scheme for the transport block 2 is Polar coding; when the size of the transport block 2 is greater than the preset first threshold, it is determined that the channel coding scheme for the transport block 2 is Turbo coding. It is assumed that, upon determination, the size of the transport block 1 is less than the preset first threshold, while the size of the transport block 2 is greater than the preset first threshold, then it is determined that the channel coding scheme for the transport block 1 is Polar coding, while the channel coding scheme for the transport block 2 is Turbo coding.

When the first transport block described above is a specific transport block of the to-be-transmitted data, for example, the to-be-transmitted data includes a transport block 1 and other transport blocks, where the transport block 1 is the first transport block, then a channel coding scheme may be determined for the transport block 1 according to Manner 1, whereas for other transport blocks, channel coding schemes may be determined by using Manner 1, or the channel coding schemes may be determined by using another manner or method.

### Manner 2:

The transmitting end determines channel coding schemes for all transport blocks of the to-be-transmitted data according to a size of a second transport block of the to-be-transmitted data and the correspondence relationship between the size of the transport block and the channel coding scheme.

In Manner 2, the transmitting end determines channel coding schemes for all transport blocks of the to-be-transmitted data according to one of the transport blocks of the to-be-transmitted data, that is, the channel coding schemes are determined according to one transport block, and the channel coding schemes are used as channel coding schemes of all the transport blocks of the to-be-transmitted data. Compared with Manner 1 where a coding scheme needs to be determined for each transport block of the to-be-transmitted data and different coding schemes need to be used for respective transport blocks in channel coding, in Manner 2, the complexity is reduced and the process and steps for determining the channel coding scheme are simplified.

Optionally, the second transport block described above may be a specific transport block of the to-be-transmitted data, or may be the largest transport block or the smallest transport block among all transport blocks of the to-be-transmitted data.

When the second transport block described above is a specific transport block of the to-be-transmitted data, for example, the to-be-transmitted data includes a plurality of transport blocks and the first one of the plurality of transport blocks is the second transport block, then the transmitting end may determine channel coding schemes for all transport blocks of the to-be-transmitted data according to a size of the first transport block and the correspondence relationship between the size of the transport block and the channel coding scheme.

When the second transport block described above is the largest transport block or the smallest transport block among all transport blocks of the to-be-transmitted data, for example, the to-be-transmitted data includes a plurality of transport blocks, where a transport block 1 and a transport block 2 are respectively the largest transport block and the smallest transport block of the to-be-transmitted data. Then, the transport block 1 may be selected as the second transport block. When the size of the transport block 1 is less than or equal to a preset second threshold, it is determined that the channel coding schemes for all transport blocks of the to-be-transmitted data are Polar coding. When the size of the transport block 1 is greater than a preset second threshold, it is determined that the channel coding schemes for all transport blocks of the to-be-transmitted data is Turbo coding.

Optionally, as an embodiment, the transmitting end determines the channel coding scheme for the to-be-transmitted data according to the numerology used for the to-be-transmitted data and a correspondence relationship between information in the numerology and the channel coding scheme.

The numerology described above may include at least one piece of resource parameter information capable of determining a time-frequency resource of the to-be-transmitted data, the time-frequency resource of the to-be-transmitted data may be determined according to the resource parameter information, and then the channel coding scheme for the to-be-transmitted data is determined according to the time-frequency resource of the to-be-transmitted data. In addition, the numerology described above may be configured by the receiving end for the transmitting end through a signaling, or may be obtained by the transmitting end according to other parameters thereof(for example, the current service type or the current working frequency point). In addition, for the receiving end, the numerology may also be obtained through a signaling of the transmitting end, or the numerology may be obtained according to other parameters of the receiving end. Alternatively, the transmitting end and the receiving end may obtain the numerology used for the to-be-transmitted data through a pre-configuration.

The numerology described above may include at least one of: a subcarrier spacing; the number of subcarriers in a preset bandwidth; the number of subcarriers included in a physical resource block (PRB); a length of an orthogonal frequency division multiplexing (OFDM) symbol; the number of points used by Fourier transform or inverse Fourier transform to generate an OFDM signal; the number of OFDM symbols included in each transmission time interval (TTI); the number of TTIs included in a preset time unit; and signal prefix information.

The subcarrier spacing is a frequency spacing between adjacent subcarriers. For example, the subcarrier spacing may be 15 Khz, 60 Khz, etc.; the number of subcarriers in the preset bandwidth refers to the number of corresponding subcarriers in each possible system bandwidth; typically, the number of subcarriers included in the PRB is an integral multiple of 6 or 12, such as 12, 24, etc.; the number of points used by the Fourier transform or the inverse Fourier transform to generate the OFDM symbol is generally an integral power of 2. The Fourier transform herein may be a fast Fourier Transform (FFT), and the inverse Fourier transform may be an inverse fast Fourier Transform (IFFT); the number of OFDM symbols included in each TTI may be an integral multiple of 2, 4, 7, or 14; the number of TTIs included in the preset time unit may be the number of TTIs included in a certain length of time such as 1 ms or 10 ms; the signal prefix information may be signal prefix information of a signal used by a device in reception and transmission of data, which may include a length of time for a cyclic prefix of the signal, where the cyclic prefix uses a regular cyclic prefix or an extended cyclic prefix.

When the numerology described above includes the subcarrier spacing information, the transmitting end may determine the channel coding scheme for the to-be-transmitted data according to a subcarrier spacing size used for the to-be-transmitted data and a correspondence relationship (the preset relationship may be predetermined) between the subcarrier spacing size and the channel coding scheme.

For example, when the to-be-transmitted data has a subcarrier spacing of 15 Khz, it is determined that the channel coding scheme for the to-be-transmitted data is tail-biting convolutional coding (TBCC); when the to-be-transmitted data has a subcarrier spacing of 60 Khz, it is determined that the channel coding scheme for the to-be-transmitted data is low-density parity check (LDPC) coding.

When the numerology described above includes the number of OFDM symbols included in each TTI, the transmitting end may determine the channel coding scheme for the to-be-transmitted data according to the number of OFDM symbols included in a corresponding TTI of the to-be-transmitted data and the correspondence relationship (the preset relationship may predetermined) between the number of OFDM symbols and the channel coding scheme.

For example, when the number of OFDM symbols included in each TTI of the to-be-transmitted data is less than a preset third threshold, it is determined that the channel coding scheme for the to-be-transmitted data is Turbo coding; when the number of OFDM symbols included in each TTI of the to-be-transmitted data is less than a preset third threshold, it is determined that the channel coding scheme for the to-be-transmitted data is Polar coding.

It should be understood that the correspondence relationship between the information in the numerology and the channel coding scheme may be a correspondence relationship between one type of information in the numerology and the channel coding scheme, or may be a correspondence relationship between several types of information in the numerology and the channel coding scheme.

That is to say, the transmitting end may determine the channel coding scheme for the to-be-transmitted data according to one type of information in the numerology and a correspondence relationship between the information and the channel coding scheme. For example, the transmitting end may also determine the channel coding scheme for the to-be-transmitted data according to the number of subcarriers in a preset bandwidth and a correspondence relationship between the number of subcarriers in the preset bandwidth and the channel coding scheme. In addition, the transmitting end may also determine the channel coding scheme for the to-be-transmitted data according to several types of information in the numerology and a correspondence relationship between these types of information and the channel coding scheme. For example, the transmitting end may determine the channel coding scheme for the to-be-transmitted data according to a subcarrier spacing, the number of OFDM symbols included in each TTI, and a correspondence relationship between the subcarrier spacing/the number of OFDM symbols included in each TTI and the channel coding scheme. Specifically, when the to-be-transmitted data has a subcarrier spacing of 15 Khz, and the number of OFDM symbols included in each TTI is less than a preset third threshold, it is determined that the channel coding scheme for the to-be-transmitted data is Turbo coding; when the to-be-transmitted data has a subcarrier spacing of 60 Khz, and the number of OFDM symbols included in each TTI is greater than a preset third threshold, it is determined that the channel coding scheme for the to-be-transmitted data is TBCC coding.

Optionally, as an embodiment, the transmitting end determines the channel coding scheme for the to-be-transmitted data according to the service type of the to-be-transmitted data and a correspondence relationship between the service type and the channel coding scheme.

The described service type of the to-be-transmitted data may include any one of LTE data, an enhanced mobile broadband (eMBB), ultra-reliable and low latency communications (URLLC), and massive machine type communications (mMTC).

Specifically, when the service type of the to-be-transmitted data is LTE data, the channel coding scheme for the to-be-transmitted data is Turbo coding; when the service type of the to-be-transmitted data is eMBB or URLLC, the channel coding scheme for the to-be-transmitted data is LDPC coding; when the service type of the to-be-transmitted data is mMTC, the channel coding scheme for the to-be-transmitted data is TBCC coding.

A corresponding channel coding scheme is selected according to the service type, and channel coding schemes having the optimal decoding complexity, demodulation performance and the like may be selected for different service types.

It should be understood that, in embodiments of the present invention, in addition to determining a channel coding scheme for to-be-transmitted data according to one of a size of a transport block of the to-be-transmitted data, a numerology used for the to-be-transmitted data and a service type of the to-be-transmitted data, the channel coding scheme for the to-be-transmitted data may also be determined according to more of the size of the transport block of the to-be-transmitted data, the numerology used for the to-be-transmitted data and the service type of the to-be-transmitted data. For example, the transmitting end may determine the channel coding scheme for the to-be-transmitted data according to a correspondence relationship between the size of the transport block of the to-be-transmitted data/the service type of the to-be-transmitted data and the channel coding scheme, specifically, when the service type of the to-be-transmitted data is eMBB and the size of the transport block of the to-be-transmitted data is less than a preset fourth threshold, it is determined that the channel coding scheme for the to-be-transmitted data is LDPC coding; when the service type of the to-be-transmitted data is mMTC and the size of the transport block of the to-be-transmitted data is greater than a preset fourth threshold, it is determined that the channel coding scheme for the to-be-transmitted data is TBCC coding.

The data transmission method in embodiments of the present invention is described above in detail from the perspective of the transmitting end with reference to FIG. 1, while the data transmission method in embodiments of the present invention will be described hereunder from the perspective of the receiving end with reference to FIG. 2. It should be understood that the description of the transmitting end corresponds to that of the receiving end. Therefore, for the portion not detailed in FIG. 2, reference may be made to the embodiments of FIG. 1.

FIG. 2 is a schematic flow chart of a data transmission method according to an embodiment of the present invention. The method of FIG. 2 includes:
210: a receiving end receives first data transmitted by a transmitting end;
220: the receiving end determines a channel coding scheme for first data according to at least one of a size of a transport block of the first data, a numerology used for the first data and a service type of the first data; and
230: the receiving end performs channel decoding for the first data based on a channel decoding scheme corresponding to the channel coding scheme for the first data.

It should be understood that, after receiving the first data, the receiving end may first determine a channel coding scheme for the first data, and then perform channel decoding for the first data by using a channel decoding scheme corresponding to the channel coding scheme for the first data. After receiving the first data, the receiving end may also directly determine a channel decoding scheme for the first data, and then perform channel decoding for the first data by using the channel decoding scheme.

In addition, both the transmitting end and the receiving end in embodiments of the present invention may be a network side device or a terminal device. The common situation is that the transmitting end is a network side device and the receiving end is a terminal device, or both the transmitting end and the receiving end are terminal devices.

Compared with a single channel coding scheme used in an LTE system, in an embodiment of the present invention, an appropriate channel coding scheme can be selected for to-be-transmitted data according to feature information of the to-be-transmitted data by determining a channel coding scheme for the to-be-transmitted data according to at least one of a size of a transport block of the to-be-transmitted data, a numerology used for the to-be-transmitted data and a service type of the to-be-transmitted data.

Optionally, as an embodiment, the receiving end determines the channel coding scheme for the first data according to the size of the transport block of the first data and a correspondence relationship between the size of the transport block and the channel coding scheme.

Optionally, as an embodiment, the receiving end determines channel coding schemes for all transport blocks of the first transport block according to a size of the first transport block of the first data and the correspondence relationship between the size of the transport block and the channel coding scheme.

Optionally, as an embodiment, the receiving end determines a channel coding scheme for the first data according to a size of a second transport block of the first data and the correspondence relationship between the size of the transport block and the channel coding scheme, where the second transport block is the largest transport block or the smallest transport block among all transport blocks of the first data.

Optionally, as an embodiment, the second transport block is the largest transport block or the smallest transport block among all transport blocks of the to-be-transmitted data.

Optionally, as an embodiment, the receiving end determines the channel coding scheme for the first data according to the numerology used for the first data and a correspondence relationship between information in the numerology and the channel coding scheme.

Optionally, as an embodiment, the numerology includes at least one of: a subcarrier spacing; the number of subcarriers in a preset bandwidth; the number of subcarriers included in a PRB; a length of an OFDM symbol; the number of points used by Fourier transform or inverse Fourier transform to generate an OFDM signal; the number of OFDM symbols included in each TTI; the number of TTIs included in a preset time unit; and signal prefix information.

Optionally, as an embodiment, the receiving end determines the channel coding scheme for the first data according to the service type of the first data and a correspondence relationship between the service type and the channel coding scheme.

Optionally, as an embodiment, the service type of the first data is any one of LTE data, eMBB, URLLC, and mMTC.

Optionally, as an embodiment, the channel coding scheme is any one of: low-density parity check LDPC coding; Turbo coding; Polar coding; Tail-Biting Convolutional Coding TBCC; and Reed-Muller RM coding.

The data transmission method in embodiments of the present invention will be described hereunder in detail by taking an example where a network side device transmits data to a terminal device.

301: a network side device determines a transport block size of a transport block used for to-be-transmitted data.

In determining a transport block size of a transport block of to-be-transmitted data, the transport block size thereof may be determined according to channel quality and a service type of the to-be-transmitted data, or may be determined according to an MCS and a frequency domain resource size of the to-be-transmitted data.

302: the network side device determines channel coding schemes for transport blocks according to transport block sizes of the respective transport blocks of the to-be-transmitted data.

For example, the to-be-transmitted data includes two transport blocks, which are a first transport block and a second transport block, respectively, where the size of the first transport block is less than 500 bits and the size of the second transport block is greater than 500 bits, then a channel coding scheme for the first transport block is LDPC coding, and a channel coding scheme for the second transport block is Turbo coding.

303: the network side device transmits a scheduling signaling to a terminal device via downlink control information (DCI).

304: the network side device transmits the to-be-transmitted data that is performed with channel coding to the terminal device.

It should be understood that Step 303 and Step 304 may occur at the same time, that is to say, the network side device may simultaneously transmit the scheduling signaling and the to-be-transmitted data that is performed with channel coding to the terminal device. In addition, the network side device may also transmit the scheduling signal to the terminal device first, and then transmit the to-be-transmitted data that is performed with channel coding to the terminal device.

305: after receiving the scheduling signaling transmitted by the network side device, the terminal device determines the transport block size of the transport block used for the to-be-transmitted data according to MCS indication information and frequency domain resource configuration information in the scheduling signaling.

For example, an MCS index value and a frequency domain resource size jointly correspond to a transport block size, and a correspondence relationship therebetween is pre-determined by the network side device and the terminal device. Then, the network side device and the terminal device may determine the size of the transport block of the to-be-transmitted data according to the MCS index value together with the frequency domain resource size.

306: the terminal device determines channel coding schemes for transport blocks according to transport block sizes of the respective transport blocks of the to-be-transmitted data.

For example, the to-be-transmitted data includes two transport blocks, which are a first transport block and a second transport block, respectively, where the size of the first transport block is less than 500 bits and the size of the second transport block is greater than 500 bits, then a channel coding scheme for the first transport block is LDPC coding and a channel coding scheme for the second transport block is Turbo coding.

307: after receiving the scheduling signaling from the network side device, the terminal device detects, according to the scheduling signaling, the encoded to-be-transmitted data transmitted by the network side device, and performs channel decoding for the transport blocks of the to-be-transmitted data based on channel decoding schemes corresponding to the channel coding schemes for the respective transport blocks determined in Step 305.

The data transmission method in embodiments of the present invention is described by taking an example where the network side device transmits data (downlink data transmission) to the terminal device in Steps 301-307 described above, while the data transmission method in embodiments of the present invention will be described hereunder in detail by taking an example where the terminal device transmits data (uplink data transmission) to the network side device. Specific steps are as follows:
401: the network side device determines the number of OFDM symbols included in one TTI when the terminal device is performing data transmission.

Specifically, the network side device may determine the number of OFDM symbols included in one TTI according to a service type that the terminal device transmits the to-be-transmitted data.

402: the network side device transmits a scheduling signaling to the terminal device via DCI, and the terminal device is scheduled to perform uplink data transmission.

The scheduling signaling includes indication information on the number of OFDM symbols included in one TTI when the terminal device is performing uplink data transmission, and the terminal device may obtain, according to the indication information, the number of OFDM symbols included in one TTI.

403: after receiving the scheduling signaling transmitted by the network side device, the terminal device determines the number of OFDM symbols included in one TTI according to the indication information in the scheduling signaling.

404: the terminal device determines a channel coding scheme for to-be-transmitted data according to the number of OFDM symbols included in one TTI.

For example, when the number of OFDM symbols in one TTI is less than 4, it is determined that the channel coding scheme for the to-be-transmitted data is TBCC coding; when the number of OFDM symbols in one TTI is less than or equal to 4 and less than 14, it is determined that the channel coding scheme for the to-be-transmitted data is Turbo coding; when the number of OFDM symbols in one TTI is greater than 14, it is determined that the channel coding scheme for the to-be-transmitted data is Polar coding.

405: the terminal device performs channel coding for the to-be-transmitted data according to the channel coding scheme determined in Step 404.

406: the terminal device transmits the to-be-transmitted data that is performed with channel coding to the network side device according to the scheduling signaling from the network device.

407: the network side device determines, according to the number of OFDM symbols included in one TTI, a channel coding scheme used by the terminal device to perform channel coding for the to-be-transmitted data.

408: the network side device performs, according to a channel decoding scheme corresponding to the channel coding scheme for the to-be-transmitted data, channel decoding for the data to be transmitted by the terminal device and performed with channel coding.

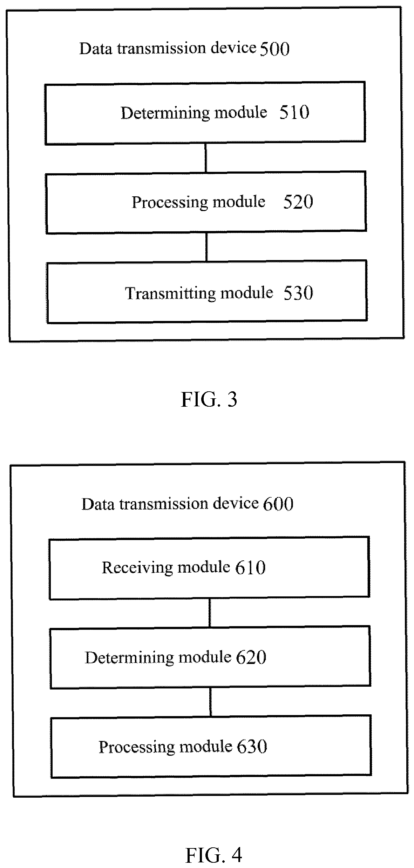

The data transmission method in embodiments of the present invention is described above in detail with reference to FIG. 1 and FIG. 2, while the data transmission device in embodiments of the present invention will be described hereunder in detail with reference to FIG. 3-FIG. 6. It should be understood that the data transmission device in FIG. 3 to FIG. 6 can perform the steps performed by the transmitting end and the receiving end in the above description. In order to avoid redundancy, details will be omitted herein.

FIG. 3 is a schematic block diagram of a data transmission device according to an embodiment of the present invention. The data transmission device 500 in FIG. 3 includes:
a determining module 510, configured to determine a channel coding scheme for to-be-transmitted data according to at least one of a size of a transport block of the to-be-transmitted data, a numerology used for the to-be-transmitted data and a service type of the to-be-transmitted data;
a processing module 520, configured to perform channel coding for the to-be-transmitted data by using the channel coding scheme for the to-be-transmitted data; and
a transmitting module 530, configured to transmit the to-be-transmitted data that is performed with the channel coding to another device.

Compared with a single channel coding scheme used in an LTE system, in an embodiment of the present invention, an appropriate channel coding scheme can be selected for to-be-transmitted data according to feature information of the to-be-transmitted data by determining a channel coding scheme for the to-be-transmitted data according to at least one of a size of a transport block of the to-be-transmitted data, a numerology used for the to-be-transmitted data and a service type of the to-be-transmitted data.

It should be understood that the data transmission device 500 in embodiments of the present invention may correspond to the transmitting end in the data transmission method according to embodiments of the present invention as shown in FIG. 1. The data transmission device 500 may perform the steps of the data transmission method as shown in FIG. 1.

Optionally, as an embodiment, the determining module 510 is specifically configured to: determine channel coding schemes for all transport blocks of the to-be-transmitted data according to the size of the transport block of the to-be-transmitted data and a correspondence relationship between the size of the transport block and the channel coding scheme.

Optionally, as an embodiment, the determining module 510 is specifically configured to: determine a channel coding scheme for a first transport block according to a size of the first transport block of the to-be-transmitted data and the correspondence relationship between the size of the transport block and the channel coding scheme.

Optionally, as an embodiment, the determining module 510 is specifically configured to: determine a channel coding scheme for the to-be-transmitted data according to a size of a second transport block of the to-be-transmitted data and the correspondence relationship between the size of the transport block and the channel coding scheme.

Optionally, as an embodiment, the second transport block is the largest transport block or the smallest transport block among all transport blocks of the to-be-transmitted data.

Optionally, as an embodiment, the determining module 510 is specifically configured to: determine the channel coding scheme for the to-be-transmitted data according to the numerology used for the to-be-transmitted data and a correspondence relationship between information in the numerology and the channel coding scheme.

Optionally, as an embodiment, the numerology includes at least one of: a subcarrier spacing; the number of subcarriers in a preset bandwidth; the number of subcarriers included in a PRB; a length of an OFDM symbol; the number of points used by Fourier transform or inverse Fourier transform to generate an OFDM signal; the number of OFDM symbols included in each TTI; the number of TTIs included in a preset time unit; and signal prefix information.

Optionally, as an embodiment, the determining module 510 is specifically configured to: determine the channel coding scheme for the to-be-transmitted data according to the service type of the to-be-transmitted data and a correspondence relationship between the service type and the channel coding scheme.

Optionally, as an embodiment, the service type of the to-be-transmitted data is any one of LTE data, eMBB, URLLC, and mMTC.

Optionally, as an embodiment, the channel coding scheme is any one of: low-density parity check LDPC coding; Turbo coding; Polar coding; Tail-Biting Convolutional Coding TBCC; and Reed-Muller RM coding.

FIG. 4 is a schematic block diagram of a data transmission device according to an embodiment of the present invention. The data transmission device 600 in FIG. 4 includes:
a receiving module 610, configured to receive first data transmitted by a transmitting end;
a determining module 620, configured to determine a channel coding scheme for first data according to at least one of a size of a transport block of the first data, a numerology used for the first data and a service type of the first data; and
a processing module 630, configured to perform channel decoding for the first data based on a channel decoding scheme corresponding to the channel coding scheme for the first data.

Compared with a single channel coding scheme used in an LTE system, in an embodiment of the present invention, an appropriate channel coding scheme can be selected for to-be-transmitted data according to feature information of the to-be-transmitted data by determining a channel coding scheme for the to-be-transmitted data according to at least one of a size of a transport block of the to-be-transmitted data, a numerology used for the to-be-transmitted data and a service type of the to-be-transmitted data.

It should be understood that the data transmission device 600 in embodiments of the present invention may correspond to the receiving end in the data transmission method according to embodiments of the present invention as shown in FIG. 2. The data transmission device 600 may perform the steps of the data transmission method as shown in FIG. 2.

Optionally, as an embodiment, the determining module 620 is specifically configured to: determine the channel coding scheme for the first data according to the size of the transport block of the first data and a correspondence relationship between the size of the transport block and the channel coding scheme.

Optionally, as an embodiment, the determining module 620 is specifically configured to: determine a channel coding scheme for a first transport block according to a size of the first transport block of the first data and the correspondence relationship between the size of the transport block and the channel coding scheme.

Optionally, as an embodiment, the determining module 620 is specifically configured to: determine channel coding schemes for all transport blocks of the first data according to a size of a second transport block of the first data and the correspondence relationship between the size of the transport block and the channel coding scheme.

Optionally, as an embodiment, the second transport block is the largest transport block or the smallest transport block among all transport blocks of the to-be-transmitted data.

Optionally, as an embodiment, the determining module 620 is specifically configured to: determine the channel coding scheme for the first data according to the numerology used for the first data and a correspondence relationship between information in the numerology and the channel coding scheme.

Optionally, as an embodiment, the numerology includes at least one of: a subcarrier spacing; the number of subcarriers in a preset bandwidth; the number of subcarriers included in a PRB; a length of an OFDM symbol; the number of points used by Fourier transform or inverse Fourier transform to generate an OFDM signal; the number of OFDM symbols included in each TTI; the number of TTIs included in a preset time unit; and signal prefix information.

Optionally, as an embodiment, the determining module 620 is specifically configured to: determine the channel coding scheme for the first data according to the service type of the first data and a correspondence relationship between the service type and the channel coding scheme.

Optionally, as an embodiment, the service type of the to-be-transmitted data is any one of LTE data, eMBB, URLLC, and mMTC.

Optionally, as an embodiment, the channel coding scheme is any one of: low-density parity check LDPC coding; Turbo coding; Polar coding; Tail-Biting Convolutional Coding TBCC; and Reed-Muller RM coding.

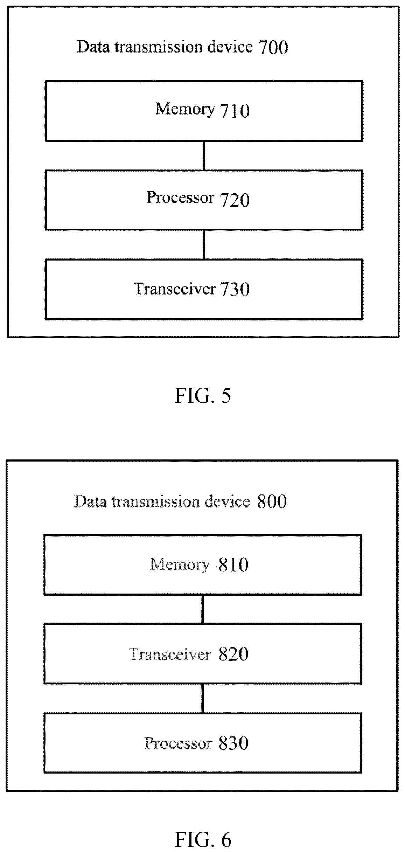

FIG. 5 is a schematic block diagram of a data transmission device according to an embodiment of the present invention. The data transmission device 700 in FIG. 5 includes:
a memory 710 configured to store a program;
a processor 720 configured to execute the program stored in the memory 710, and when the program is executed, the processor 720 is configured to determine a channel coding scheme for to-be-transmitted data according to at least one of a size of a transport block of the to-be-transmitted data, a numerology used for the to-be-transmitted data and a service type of the to-be-transmitted data;
the processer 720 is further configured to perform channel coding for the to-be-transmitted data by using the channel coding scheme for the to-be-transmitted data; and
a transceiver 730 configured to transmit the to-be-transmitted data that is performed with the channel coding to another device.

Compared with a single channel coding scheme used in an LTE system, in an embodiment of the present invention, an appropriate channel coding scheme can be selected for to-be-transmitted data according to feature information of the to-be-transmitted data by determining a channel coding scheme for the to-be-transmitted data according to at least one of a size of a transport block of the to-be-transmitted data, a numerology used for the to-be-transmitted data and a service type of the to-be-transmitted data.

It should be understood that the data transmission device 700 in embodiments of the present invention may correspond to the transmitting end in the data transmission method according to embodiments of the present invention as shown in FIG. 1. The data transmission device 700 may perform the respective steps of the data transmission method as shown in FIG. 1.

Optionally, as an embodiment, the processor 720 is specifically configured to: determine the channel coding scheme for the to-be-transmitted data according to the size of the transport block of the to-be-transmitted data and the correspondence relationship between the size of the transport block and the channel coding scheme.

Optionally, as an embodiment, the processor 720 is specifically configured to: determine a channel coding scheme for a first transport block according to a size of the first transport block of the to-be-transmitted data and the correspondence relationship between the size of the transport block and the channel coding scheme.

Optionally, as an embodiment, the processor 720 is specifically configured to: determine channel coding schemes for all transport blocks of the to-be-transmitted data according to a size of a second transport block of the to-be-transmitted data and the correspondence relationship between the size of the transport block and the channel coding scheme.

Optionally, as an embodiment, the second transport block is the largest transport block or the smallest transport block among all transport blocks of the to-be-transmitted data.

Optionally, as an embodiment, the processor 720 is specifically configured to: determine the channel coding scheme for the to-be-transmitted data according to the numerology used for the to-be-transmitted data and a correspondence relationship between information in the numerology and the channel coding scheme.

Optionally, as an embodiment, the numerology includes at least one of: a subcarrier spacing; the number of subcarriers in a preset bandwidth; the number of subcarriers included in a PRB; a length of an OFDM symbol; the number of points used by Fourier transform or inverse Fourier transform to generate an OFDM signal; the number of OFDM symbols included in each TTI; the number of TTIs included in a preset time unit; and signal prefix information.

Optionally, as an embodiment, the processor 720 is specifically configured to: determine the channel coding scheme for the to-be-transmitted data according to the service type of the to-be-transmitted data and a correspondence relationship between the service type and the channel coding scheme.

Optionally, as an embodiment, the service type of the to-be-transmitted data is any one of LTE data, eMBB, URLLC, and mMTC.

Optionally, as an embodiment, the channel coding scheme is any one of: low-density parity check (LDPC) coding; Turbo coding; Polar coding; Tail-Biting Convolutional Coding (TBCC); and Reed-Muller (RM) coding.

FIG. 6 is a schematic block diagram of a data transmission device according to an embodiment of the present invention. The data transmission device 800 in FIG. 6 includes:
a memory 810 configured to store a program;
a transceiver 820 configured to receive first data transmitted by a transmitting end; and
a processor 830 configured to execute the program stored in the memory 810, and when the program is executed, the processor 830 is configured to determine a channel coding scheme for first data according to at least one of a size of a transport block of the first data, a numerology used for the first data and a service type of the first data;
the processer 830 is further configured to perform channel decoding for the first data based on a channel decoding scheme corresponding to the channel coding scheme for the first data.

Compared with a single channel coding scheme used in an LTE system, in an embodiment of the present invention, an appropriate channel coding scheme can be selected for to-be-transmitted data according to feature information of the to-be-transmitted data by determining a channel coding scheme for the to-be-transmitted data according to at least one of a size of a transport block of the to-be-transmitted data, a numerology used for the to-be-transmitted data and a service type of the to-be-transmitted data.

It should be understood that the data transmission device 800 in embodiments of the present invention may correspond to the receiving end in the data transmission method according to embodiments of the present invention as shown in FIG. 2. The data transmission device 800 may perform the steps of the data transmission method as shown in FIG. 2.

Optionally, as an embodiment, the processor 830 is specifically configured to: determine the channel coding scheme for the first data according to the size of the transport block of the first data and a correspondence relationship between the size of the transport block and the channel coding scheme.

Optionally, as an embodiment, the processor 830 is specifically configured to: determine a channel coding scheme for a first transport block according to a size of the first transport block of the first data and the correspondence relationship between the size of the transport block and the channel coding scheme.

Optionally, as an embodiment, the processor 830 is specifically configured to: determine channel coding schemes for all transport blocks of the first data according to a size of a second transport block of the first data and the correspondence relationship between the size of the transport block and the channel coding scheme.

Optionally, as an embodiment, the second transport block is the largest transport block or the smallest transport block among all transport blocks of the to-be-transmitted data.

Optionally, as an embodiment, the processor 830 is specifically configured to: determine the channel coding scheme for the first data according to the numerology used for the first data and a correspondence relationship between information in the numerology and the channel coding scheme.

Optionally, as an embodiment, the numerology includes at least one of: a subcarrier spacing; the number of subcarriers in a preset bandwidth; the number of subcarriers included in a PRB; a length of an OFDM symbol; the number of points used by Fourier transform or inverse Fourier transform to generate an OFDM signal; the number of OFDM symbols included in each TTI; the number of TTIs included in a preset time unit; and signal prefix information.

Optionally, as an embodiment, the processor 830 is specifically configured to: determine the channel coding scheme for the to-be-transmitted data according to the service type of the to-be-transmitted data and a correspondence relationship between the service type and the channel coding scheme.

Optionally, as an embodiment, the service type of the to-be-transmitted data is any one of LTE data, eMBB, URLLC, and mMTC.

Optionally, as an embodiment, the channel coding scheme is any one of: low-density parity check LDPC coding; Turbo coding; Polar coding; Tail-Biting Convolutional Coding TBCC; and Reed-Muller RM coding.

It may be known to persons of ordinary skill in the art that, the exemplary units and algorithm steps described with reference to the embodiments disclosed herein may be implemented by electronic hardware or a combination of electronic hardware and computer software. The situation whether these functions are performed by hardware or software depends on specific applications and design constraints of the technical solutions. Persons skilled in the art may implement the described functions by using different methods for each specific application, and such implementation should not be regarded as going beyond the scope of the present invention.

It may be clearly understood by a person skilled in the art that, for the purpose of convenient and brief description, reference may be made to the corresponding process in the foregoing method embodiments for specific working processes of the above-described systems, apparatuses and units, and details will not be described herein again.

In several embodiments provided in the present invention, it should be understood that the disclosed systems, apparatuses, and methods may be implemented in other manners. For example, the described apparatus embodiments are merely exemplary. For instance, the division of the units is merely a division of logical functions and there may be other divisions during an actual implementation. For instance, a plurality of units or components may be combined or integrated into another system, or some features may be omitted or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, that is, may be located in one position, or may be distributed on a plurality of network units. A part or all of the units may be selected according to actual needs to achieve the objectives of the solutions of the embodiments.

In addition, functional units in the embodiments of the present invention may be integrated into one processing unit, or each of the units may exist alone physically, or two or more units may be integrated into one unit.

If implemented in a form of a software functional unit and sold or used as an independent product, the functions may be stored in a computer-readable storage medium. Based on such an understanding, the technical solutions of the present invention essentially, or the part contributing to the prior art, or a part of the technical solutions may be implemented in a form of a software product. The computer software product is stored in a storage medium including several instructions for enabling a computer device (which may be a personal computer, a server, or a network device) to perform all or a part of the steps of the methods described in the embodiments of the present invention. The foregoing storage medium includes: any medium that can store program codes, such as a USB flash disk, a mobile hard disk, a read-only memory (ROM), a random access memory (RAM), a magnetic disk, or an optical disc.

The above descriptions are merely specific embodiments of the present invention; however, the protection scope of the present invention is not limited thereto. Any modification or replacement that may be readily envisaged of by persons skilled in the art within the technical scope disclosed in the present invention should fall into the protection scope of the present invention. Thus, the protection scope of the present invention shall be subject to the claims.

## Claims

1. A data transmission method, comprising:
determining, by a transmitting end, a channel coding scheme for to-be-transmitted data according to at least one of a size of a transport block of the to-be-transmitted data, a numerology used for the to-be-transmitted data and a service type of the to-be-transmitted data;
performing, by the transmitting end, channel coding for the to-be-transmitted data by using the channel coding scheme for the to-be-transmitted data; and
transmitting, by the transmitting end, the to-be-transmitted data that is performed with the channel coding to a receiving end.

2. The method according to claim 1, wherein determining, by the transmitting end, the channel coding scheme for the to-be-transmitted data according to the size of the transport block of the to-be-transmitted data comprises:
determining, by the transmitting end, the channel coding scheme for the to-be-transmitted data according to the size of the transport block of the to-be-transmitted data and a correspondence relationship between the size of the transport block and the channel coding scheme.

3. The method according to claim 2, wherein the determining, by the transmitting end, the channel coding scheme for the to-be-transmitted data according to the size of the transport block of the to-be-transmitted data and the correspondence relationship between the size of the transport block and the channel coding scheme comprises:
determining, by the transmitting end, a channel coding scheme for a first transport block according to a size of the first transport block of the to-be-transmitted data and the correspondence relationship between the size of the transport block and the channel coding scheme.

4. The method according to claim 2, wherein the determining, by the transmitting end, the channel coding scheme for the to-be-transmitted data according to the size of the transport block of the to-be-transmitted data and the correspondence relationship between the size of the transport block and the channel coding scheme comprises:
determining, by the transmitting end, channel coding schemes for all transport blocks of the to-be-transmitted data according to a size of a second transport block of the to-be-transmitted data and the correspondence relationship between the size of the transport block and the channel coding scheme.

5. The method according to claim 4, wherein the second transport block is the largest transport block or the smallest transport block among all transport blocks of the to-be-transmitted data.

6. The method according to any one of claims 1-5, wherein determining, by the transmitting end, the channel coding scheme for the to-be-transmitted data according to the numerology used for the to-be-transmitted data comprises:
determining, by the transmitting end, the channel coding scheme for the to-be-transmitted data according to the numerology used for the to-be-transmitted data and a correspondence relationship between information in the numerology and the channel coding scheme.

7. The method according to claim 6, wherein the numerology comprises at least one of:
a subcarrier spacing;
the number of subcarriers in a preset bandwidth;
the number of subcarriers comprised in a physical resource block (PRB);
a length of an orthogonal frequency division multiplexing (OFDM) symbol;
the number of points used by Fourier transform or inverse Fourier transform to generate an OFDM signal;
the number of OFDM symbols comprised in each transmission time interval (TTI);
the number of TTIs comprised in a preset time unit; and
signal prefix information.

8. The method according to any one of claims 1-7, wherein determining, by the transmitting end, the channel coding scheme for the to-be-transmitted data according to the service type of the to-be-transmitted data comprises:
determining, by the transmitting end, the channel coding scheme for the to-be-transmitted data according to the service type of the to-be-transmitted data and a correspondence relationship between the service type and the channel coding scheme.

9. The method according to claim 8, wherein the service type of the to-be-transmitted data is any one of long term evolution system (LTE) data, an enhanced mobile broadband (eMBB), ultra-reliable and low latency communications (URLLC), and massive machine type communications (mMTC).

10. The method according to any one of claims 1-9, wherein the channel coding scheme is any one of:
low-density parity check (LDPC) coding;
Turbo coding;
Polar coding;
Tail-Biting Convolutional Coding (TBCC); and
Reed-Muller (RM) coding.

11. A data transmission method, comprising:
receiving, by a receiving end, first data transmitted by a transmitting end;
determining, by the receiving end, a channel coding scheme for first data according to at least one of a size of a transport block of the first data, a numerology used for the first data and a service type of the first data; and
performing, by the receiving end, channel decoding for the first data based on a channel decoding scheme corresponding to the channel coding scheme for the first data.

12. The method according to claim 11, wherein determining, by the receiving end, the channel coding scheme for the first data according to the size of the transport block of the first data comprises:
determining, by the receiving end, the channel coding scheme for the first data according to the size of the transport block of the first data and a correspondence relationship between the size of the transport block and the channel coding scheme.

13. The method according to claim 12, wherein the determining, by the receiving end, the channel coding scheme for the first data according to the size of the transport block of the first data and the correspondence relationship between the size of the transport block and the channel coding scheme comprises:
determining, by the receiving end, a channel coding scheme for a first transport block according to a size of the first transport block of the first data and the correspondence relationship between the size of the transport block and the channel coding scheme.

14. The method according to claim 12, wherein the determining, by the receiving end, the channel coding scheme for the first data according to the size of the transport block of the first data and the correspondence relationship between the size of the transport block and the channel coding scheme comprises:
determining, by the receiving end, channel coding schemes for all transport blocks of the first data according to a size of a second transport block of the first data and the correspondence relationship between the size of the transport block and the channel coding scheme.

15. The method according to claim 14, wherein the second transport block is the largest transport block or the smallest transport block among all transport blocks of the to-be-transmitted data.

16. The method according to any one of claims 11-15, wherein determining, by the receiving end, the channel coding scheme for the first data according to the numerology used for the first data comprises:
determining, by the receiving end, the channel coding scheme for the first data according to the numerology used for the first data and a correspondence relationship between information in the numerology and the channel coding scheme.

17. The method according to claim 16, wherein the numerology comprises at least one of:
a subcarrier spacing;
the number of subcarriers in a preset bandwidth;
the number of subcarriers comprised in a physical resource block (PRB);
a length of an orthogonal frequency division multiplexing (OFDM) symbol;
the number of points used by Fourier transform or inverse Fourier transform to generate an OFDM signal;
the number of OFDM symbols comprised in each transmission time interval (TTI);
the number of TTIs comprised in a preset time unit; and
signal prefix information.

18. The method according to any one of claims 11-17, wherein the determining, by the receiving end, the channel coding scheme for the first data according to the service type of the first data comprises:
determining, by the receiving end, the channel coding scheme for the first data according to the service type of the first data and a correspondence relationship between the service type and the channel coding scheme.

19. The method according to claim 18, wherein the service type of the first data is any one of long term evolution system (LTE) data, an enhanced mobile broadband (eMBB), ultra-reliable and low latency communications (URLLC), and massive machine type communications (mMTC).

20. The method according to any one of claims 11-19, wherein the channel coding scheme is any one of:
low-density parity check (LDPC) coding;
Turbo coding;
Polar coding;
Tail-Biting Convolutional Coding (TBCC); and
Reed-Muller (RM) coding.

21. A data transmission device, comprising:
a determining module, configured to determine a channel coding scheme for to-be-transmitted data according to at least one of a size of a transport block of the to-be-transmitted data, a numerology used for the to-be-transmitted data and a service type of the to-be-transmitted data;
a processing module, configured to perform channel coding for the to-be-transmitted data by using the channel coding scheme for the to-be-transmitted data; and
a transmitting module, configured to transmit the to-be-transmitted data that is performed with the channel coding to another device.

22. The device according to claim 21, wherein the determining module is specifically configured to:
determine the channel coding scheme for the to-be-transmitted data according to the size of the transport block of the to-be-transmitted data and a correspondence relationship between the size of the transport block and the channel coding scheme.

23. The device according to claim 22, wherein the determining module is specifically configured to:
determine a channel coding scheme for a first transport block according to a size of the first transport block of the to-be-transmitted data and the correspondence relationship between the size of the transport block and the channel coding scheme.

24. The device according to claim 22, wherein the determining module is specifically configured to:
determine channel coding schemes for all transport blocks of the to-be-transmitted data according to a size of a second transport block of the to-be-transmitted data and the correspondence relationship between the size of the transport block and the channel coding scheme.

25. The device according to claim 24, wherein the second transport block is the largest transport block or the smallest transport block among all transport blocks of the to-be-transmitted data.

26. The device according to any one of claims 21-25, wherein the determining module is specifically configured to:
determine the channel coding scheme for the to-be-transmitted data according to the numerology used for the to-be-transmitted data and a correspondence relationship between information in the numerology and the channel coding scheme.

27. The device according to 26, wherein the numerology comprises at least one of:
a subcarrier spacing;
the number of subcarriers in a preset bandwidth;
the number of subcarriers comprised in a physical resource block (PRB);
a length of an orthogonal frequency division multiplexing (OFDM) symbol;
the number of points used by Fourier transform or inverse Fourier transform to generate an OFDM signal;
the number of OFDM symbols comprised in each transmission time interval (TTI);
the number of TTIs comprised in a preset time unit; and
signal prefix information.

28. The device according to any one of claims 21-27, wherein the determining module is specifically configured to:
determine the channel coding scheme for the to-be-transmitted data according to the service type of the to-be-transmitted data and a correspondence relationship between the service type and the channel coding scheme.

29. The device according to claim 28, wherein the service type of the to-be-transmitted data is any one of long term evolution system (LTE) data, an enhanced mobile broadband (eMBB), ultra-reliable and low latency communications (URLLC), and massive machine type communications (mMTC).

30. The device according to any one of claims 21-29, wherein the channel coding scheme is any one of:
low-density parity check (LDPC) coding;
Turbo coding;
Polar coding;
Tail-Biting Convolutional Coding (TBCC); and
Reed-Muller (RM) coding.

31. A data transmission device, comprising:
a receiving module, configured to receive first data transmitted by a transmitting end;
a determining module, configured to determine a channel coding scheme for first data according to at least one of a size of a transport block of the first data, a numerology used for the first data and a service type of the first data; and
a processing module, configured to perform channel decoding for the first data based on a channel decoding scheme corresponding to the channel coding scheme for the first data.

32. The device according to claim 31, wherein the determining module is specifically configured to:
determine the channel coding scheme for the first data according to the size of the transport block of the first data and a correspondence relationship between the size of the transport block and the channel coding scheme.

33. The device according to claim 32, wherein the determining module is specifically configured to:
determine a channel coding scheme for a first transport block according to a size of the first transport block of the first data and the correspondence relationship between the size of the transport block and the channel coding scheme.

34. The device according to claim 32, wherein the determining module is specifically configured to:
determine channel coding schemes for all transport blocks of the first data according to a size of a second transport block of the first data and the correspondence relationship between the size of the transport block and the channel coding scheme.

35. The device according to claim 34, wherein the second transport block is the largest transport block or the smallest transport block among all transport blocks of the to-be-transmitted data.

36. The device according to any one of claims 31-35, wherein the determining module is specifically configured to:
determine the channel coding scheme for the first data according to the numerology used for the first data and a correspondence relationship between information in the numerology and the channel coding scheme.

37. The device according to claim 36, wherein the numerology comprises at least one of:
a subcarrier spacing;
the number of subcarriers in a preset bandwidth;
the number of subcarriers comprised in a physical resource block (PRB);
a length of an orthogonal frequency division multiplexing (OFDM) symbol;
the number of points used by Fourier transform or inverse Fourier transform to generate an OFDM signal;
the number of OFDM symbols comprised in each transmission time interval (TTI);
the number of TTIs comprised in a preset time unit; and
signal prefix information.

38. The device according to any one of claims 31-37, wherein the determining module is specifically configured to:
determine the channel coding scheme for the first data according to the service type of the first data and a correspondence relationship between the service type and the channel coding scheme.

39. The device according to claim 38, wherein the service type of the first data is any one of long term evolution system (LTE) data, an enhanced mobile broadband (eMBB), ultra-reliable and low latency communications (URLLC), and massive machine type communications (mMTC).

40. The device according to any one of claims 31-39, wherein the channel coding scheme is any one of:
low-density parity check (LDPC) coding;
Turbo coding;
Polar coding;
Tail-Biting Convolutional Coding (TBCC); and
Reed-Muller (RM) coding.
